(19) Europäisches Patentamt
European Patent Office
Office européen des brevets

(11) **EP 1 275 159 B1**

(12) **EUROPÄISCHE PATENTSCHRIFT**

(45) Veröffentlichungstag und Bekanntmachung des Hinweises auf die Patenterteilung:
**11.10.2017 Patentblatt 2017/41**

(21) Anmeldenummer: **01942963.8**

(22) Anmeldetag: **19.04.2001**

(51) Int Cl.:
*H01L 33/02* *(2010.01)*    *H01L 33/20* *(2010.01)*

(86) Internationale Anmeldenummer:
**PCT/DE2001/001513**

(87) Internationale Veröffentlichungsnummer:
**WO 2001/080322 (25.10.2001 Gazette 2001/43)**

(54) **LUMINESZENZDIODENCHIP UND VERFAHREN ZU DESSEN HERSTELLUNG**

HIGH-RADIANCE LED CHIP AND A METHOD FOR PRODUCING THE SAME

PUCE DE DEL ET SON PROCEDE DE PRODUCTION

(84) Benannte Vertragsstaaten:
**DE FR GB**

(30) Priorität: **19.04.2000 DE 10019665**

(43) Veröffentlichungstag der Anmeldung:
**15.01.2003 Patentblatt 2003/03**

(73) Patentinhaber: **OSRAM Opto Semiconductors GmbH**
**93055 Regensburg (DE)**

(72) Erfinder:
- **BOGNER, Georg**
**93138 Lappersdorf (DE)**
- **KUGLER, Siegmar**
**93055 Regensburg (DE)**
- **NEUMANN, Gerald**
**81541 München (DE)**
- **NIRSCHL, Ernst**
**93173 Wenzenbach (DE)**
- **OBERSCHMID, Raimund**
**93161 Sinzing (DE)**
- **SCHLERETH, Karl-Heinz**
**93133 Burglengenfeld (DE)**
- **SCHOENFELD, Olaf**
**81925 München (DE)**
- **STATH, Norbert**
**93049 Regensburg (DE)**

(74) Vertreter: **Epping - Hermann - Fischer**
**Patentanwaltsgesellschaft mbH**
**Schloßschmidstraße 5**
**80639 München (DE)**

(56) Entgegenhaltungen:
**EP-A- 0 101 368     EP-A- 0 405 757**
**EP-A- 0 562 880     EP-A- 0 977 280**
**WO-A-96/37000      WO-A-99/00851**
**DE-A- 2 633 942     GB-A- 2 326 023**
**US-A- 4 339 689     US-A- 5 264 715**
**US-A- 5 705 834**

- **PATENT ABSTRACTS OF JAPAN vol. 008, no. 243 (E-277), 8. November 1984 (1984-11-08) & JP 59 121985 A (NIPPON DENKI KK), 14. Juli 1984 (1984-07-14)**
- **PATENT ABSTRACTS OF JAPAN vol. 014, no. 336 (E-0953), 19. Juli 1990 (1990-07-19) & JP 02 113524 A (HITACHI LTD;OTHERS: 01), 25. April 1990 (1990-04-25)**
- **PATENT ABSTRACTS OF JAPAN vol. 010, no. 313 (E-448), 24. Oktober 1986 (1986-10-24) & JP 61 125092 A (NEC CORP), 12. Juni 1986 (1986-06-12)**
- **PATENT ABSTRACTS OF JAPAN vol. 1997, no. 02, 28. Februar 1997 (1997-02-28) -& JP 08 255933 A (OMRON CORP), 1. Oktober 1996 (1996-10-01)**

EP 1 275 159 B1

**Beschreibung**

Die Erfindung bezieht sich auf einen Lumineszenzdiodenchip nach dem Oberbegriff des Patentanspruchs 1 sowie ein Herstellungsverfahren hierfür nach dem Oberbegriff des Patentanspruchs 18. Halbleitermaterialien für Lumineszenzdiodenchips weisen zum Teil einen Brechungsindex von deutlich über 3 auf. Das bei herkömmlichen Lumineszenzdiodenbauelementen an den Chip angrenzende Medium, für gewöhnlich ist dieses Luft oder Kunststoff, weist einen deutlich niedrigeren Brechungsindex auf. Der damit verbundene große Brechungsindexsprung an der Grenzfläche zwischen Lumineszenzdiodenchip und angrenzendem Medium führt zu einem verhältnismäßig kleinen Grenzwinkel der Totalreflexion, so dass ein Großteil der in einem aktiven Bereich des Chips erzeugten elektromagnetischen Strahlung von dieser Grenzfläche in den Chip zurückreflektiert wird.

Aus diesem Grund wird nur ein sehr geringer Anteil der in der aktiven Zone erzeugten Strahlung direkt aus dem Chip ausgekoppelt. Bei herkömmlichen Lumineszenzdiodenchips errechnet sich je ebene Auskoppelfläche ein Auskoppelanteil von nur wenigen Prozent.

In der US 5,233,204 ist zur Verbesserung der Lichtauskopplung aus Leuchtdiodenchips eine dicke transparente Schicht vorgeschlagen, die zusätzlich zu den lichterzeugenden Schichten epitaktisch aufgebracht wird und die den Lichtauskoppelanteil durch die Vorderseite des Chips erhöhen soll.

Weiterhin bekannt ist die Verwendung von hochbrechenden transparenten Vergussmassen, die jedoch unter anderem aus Kostengründen zu keiner verbreiteten Anwendung gefunden hat. Darüber hinaus weisen die besten bisher zur Verfügung stehenden Vergussmassen einen Brechungsindex von höchstens n=1,6 auf, was noch einen zu hohen Sprung an der Auskoppelfläche des lichtemittierenden Halbleiterbauelements und damit hohe Reflexionsverluste zur Folge hat. Weiterhin haben die hochtransparenten Vergussmassen unerwünschte chemische und mechanische Eigenschaften, was die technische Massenanwendung ebenfalls einschränkt.

Lumineszenzdiodenchips sind beispielsweise in einer der Druckschriften WO 96/37000 A, EP 0 101 368 A und DE 26 33 942 A beschrieben.

Aufgabe der Erfindung ist es, einen Lumineszenzdiodenchip zur Verfügung zu stellen, bei dem das Verhältnis von erzeugter zu ausgekoppelter Strahlung gegenüber herkömmlichen Chips verbessert ist und der in herkömmliche LED-Gehäusebauformen montierbar ist. Gleichzeitig soll ein Verfahren zu dessen Herstellung angegeben werden, das gegenüber herkömmlichen Verfahren zur Herstellung von Lumineszenzdiodenchips nur einen geringen technischen Mehraufwand erfordert.

Diese Aufgabe wird durch einen Lumineszenzdiodenchip mit den Merkmalen des Patentanspruches 1 bzw. durch ein Verfahren mit den Merkmalen des Patentanspruches 18 gelöst.

Vorteilhafte Weiterbildungen des Lumineszenzdiodenchips und des Verfahrens sind Gegenstand der Unteransprüche 2 bis 17 bzw. 19 bis 21.

Mit der Erfindung wird die Strahlungsausbeute bei einem Lumineszenzdiodenchip durch Einengung des lichtemittierenden Bereichs auf eine Fläche, die kleiner ist als die Querschnittsfläche des Lumineszenzdiodenchips, erhöht. Gegenüber der üblichen Ausbildung der lichtemittierenden Fläche über den gesamten Querschnitt des Lumineszenzdiodenchips ist sogar Erhöhung der Auskopplung um mehr als 30% möglich.

Erfindungsgemäß ist ein Lumineszenzdiodenchip mit einem strahlungsemittierenden aktiven Bereich mit einer lateralen Querschnittsfläche $F_L$ und einer dem strahlungsemittierenden aktiven Bereich in Abstrahlungsrichtung nachgeordneten strahlungsdurchlässigen Fensterschicht mit einem Brechungsindex ns, die zur Lichtauskopplung eine laterale Querschnittsfläche $F_C$ aufweist und die eine Auskoppelfläche besitzt, an die ein Medium mit dem Brechungsindex $n_M$ angrenzt, vorgesehen, wobei die Querschnittsfläche $F_L$ des strahlungsemittierenden aktiven Bereichs kleiner als die Querschnittfläche $F_C$ der Auskoppelfläche ist, so dass die Relation

$$F_L \leq \left( \frac{n_M}{n_s} \right)^2 \cdot F_C$$

erfüllt ist. Die Querschnittsfläche $F_C$ bezieht sich dabei auf die zur Lichtauskopplung zur Verfügung stehenden oder zur Lichtauskopplung vorgesehenen Bereiche der Fensterschicht. Unter einer Fensterschicht ist hierbei sowohl eine einzelne Schicht als auch eine mehrschichtige Struktur zu verstehen, die insgesamt die Funktion einer Fensterschicht erfüllt.

Nach einer besonders bevorzugten Ausgestaltung der Erfindung ist vorgesehen, dass die Lichtemissionsbegrenzungseinrichtung dergestalt ausgebildet ist, dass der Stromfluss innerhalb des Leuchtdiodenchips, insbesondere in und/oder durch die aktive Schicht, auf den lichtemittierenden Bereich begrenzt ist. Hierdurch kann besonders einfach die Emission des Lichts erfindungsgemäß auf einen kleineren Bereich beschränkt werden.

Für die Dicke H der Fensterschicht kann gelten:

$$H < \left( \frac{n_s}{n_M} \right) \cdot \frac{1}{2} \cdot C$$

wobei C die laterale Querschnittslänge der Fensterschicht bzw. der Lichtaustrittsfläche, ns den Brechungsindex des Materials der aktiven Schicht oder der Fensterschicht und $n_M$ den Brechungsindex des an die Fensterschicht angrenzenden Materials ist. Der hierbei erzielte Vorteil liegt in einer weiteren Steigerung der ausgekoppelten Lichtmenge.

Unter einer lateralen Querschnittslänge ist hier und im Folgenden die charakteristische Ausdehnung der entsprechenden Querschnittfläche zu verstehen. Bei einer quadratischen Fläche beispielsweise ist dies die Seitenlänge, bei einer kreisförmigen Fläche der Durchmesser. Bei einer anderen Flächenform kann als laterale Querschnittslänge ein Wert herangezogen werden, der zwischen dem maximalen und dem minimalen durch den Flächenschwerpunkt verlaufenden Durchmesser liegt.

Für die Dicke H der an die aktive Schicht angrenzenden Fensterschicht gilt:

$$H = (C - D) \cdot \left(2 \cdot \left(n_S / n_M\right)\right)^{-1}$$

wobei C die laterale Querschnittslänge der Fensterschicht, D die laterale Querschnittslänge des lichtemittierenden Bereiches der aktiven Schicht, $n_S$ der Brechungsindex der zu durchstrahlenden Fensterschicht und $n_M$ der Brechungsindex des an die Fensterschicht angrenzenden Materials ist. Bis zu dieser Höhe wird eine Totalreflexion an den Seitenflächen der Fensterschicht weitgehend vermieden, so dass eine Auskopplung der erzeugten Strahlung durch die Seitenflächen möglich ist.

Nach einer weiteren bevorzugten Ausführungsform der Erfindung besteht der lichtemittierende Bereich aus mehreren, in regelmäßigem Abstand zueinander angeordneten Teilleuchtbereichen (33 bis 35) der aktiven Schicht (3), wobei für die Gesamtfläche $F_L$ der Teilleuchtbereiche gilt:

$$\sum_i F_{Li} = F_L \leq \left(n_M / n_S\right) \cdot F_C$$

wobei $F_C$ die Querschnittsfläche bzw. die Grundfläche,der Fensterschicht und somit die Lichtaustrittsfläche, $F_{Li}$ die Flächen der einzelnen Teilleuchtbereiche; ns der Brechungsindex der aktiven Schicht oder der Fensterschicht und $n_M$ der Brechungsindex des an die Fensterschicht angrenzenden Materials ist. Hierdurch wird in ebenso vorteilhafter Weise wie bei einem zentralen lichtemittierenden Bereich der aktiven Schicht die Lichtauskopplung aus dem Leuchtdiodenchip optimiert. Dem folgend gilt vorteilhafterweise für die Dicke H der Fensterschicht:

$$H = p \cdot A$$

wobei A der regelmäßige Abstand der einzelnen Teilleuchtbereiche und p ein zwischen 0,5 und 5 wählbarer Faktor ist.

Mit Vorteil ist eine das aus dem Leuchtdiodenchip austretende Licht bündelnde optische Einrichtung vorgesehen, die auf der Oberfläche der Fensterschicht ausgebildet ist. Hierdurch kann die Form des austretenden Lichtbündels bestimmt und die Auskopplung durch geeignete Material- und Formwahl weiter gesteigert werden.

Eine bevorzugte Ausführungsform der Erfindung sieht vor, dass die optische Einrichtung durch eine oder mehrere, vorzugsweise sphärische, Linse(n) ausgebildet ist, deren Mittelpunkt über dem Schwerpunkt des lichtemittierenden Bereichs oder über jeweils dem Schwerpunkt der einzelnen Teilleuchtbereiche liegt.

Eine ebenso bevorzugte Ausführungsform der Erfindung sieht vor, dass die optische Einrichtung durch eine oder mehrere Fresnel'sche Linse(n) ausgebildet ist, deren Mittelpunkt über dem Schwerpunkt des lichtemittierenden Bereichs oder über jeweils dem Schwerpunkt der einzelnen Teilleuchtbereiche liegt.

Vorzugsweise ist die optische Einrichtung auf der Oberfläche der Fensterschicht aufgesetzt oder aufgeformt oder aus der Fensterschicht selbst ausgebildet oder ausgeformt.

In weiterer Ausgestaltung der Erfindung ist die Lichtemissionsbegrenzungseinrichtung durch eine Begrenzung der aktiven Schicht gebildet, wobei die Leuchtfähigkeit der aktiven Schicht auf den lichtemittierenden Bereich beschränkt ist.

Eine vorteilhafte Ausführungsform der Erfindung ist, dass die Lichtemissionsbegrenzungseinrichtung durch eine auf oder an der aktiven Schicht ausgebildete Isolierungsschicht aus einem für das Emissionslicht der aktiven Schicht wenigstens teilweise undurchsichtigem und/oder begrenzt durchscheinendem Material gebildet ist. Hierdurch kann die aktive Schicht, wie bisher üblich, als eine durchgehende Schicht im noch viele einzelne lichtemittierende Halbleiterbauelemente enthaltenden Wafer verlaufen.

Eine weitere vorteilhafte Ausführungsform der Erfindung sieht vor, dass die Lichtemissionsbegrenzungseinrichtung durch eine auf oder an der aktiven Schicht und zwischen der aktiven Schicht und einer Stromzuführung ausgebildeten Isolierungsschicht gebildet ist, die die Stromzuführung bzw. den Stromfluss zur bzw. durch.die aktive Schicht in Bereichen außerhalb des lichtemittierenden Bereichs minimiert. Auch hierbei kann die aktive Schicht als eine durchgehende Schicht im noch viele einzelne lichtemittierende Halbleiterbauelemente enthaltenden Wafer verlaufen.

Zweckmäßig besteht die Isolierungsschicht aus einer nichtleitenden Oxidschicht, die an der der Lichtaustrittsfläche gegenüberliegen Seite der Fensterschicht aufgebracht ist. Hierdurch kann die Maskierung der Stromzuführung in besonders einfacher und billiger Weise realisiert werden. Mit Vorteil wird die Oxidschicht durch eine Oxidierung des bereits vorhandenen Materials hergestellt.

Ebenso zweckmäßig ist die Lichtemissionsbegrenzungseinrichtung durch die Formgestaltung der Stromzuführung dergestalt gebildet, dass die Stromzuführung nur in Kontakt-Bereichen in elektrisch leitenden Kontakt mit der aktiven Schicht steht.

Nach einer bevorzugten Ausführungsform der Erfindung ist eine zweite Stromzuführung durch einen auf der Lichtaustrittsfläche oder auf der optischen Einrichtung diese nicht vollständig bedeckenden elektrischen Kontakt ausgebildet. Auf dieser kann in üblicher Weise ein Bonddraht zur Kontaktierung befestigt sein.

Ebenso vorteilhaft ist eine zweite Stromzuführung durch einen mit der Fensterschicht zwischen der aktiven Schicht und der Lichtaustrittsfläche verbundenen elektrischen Kontakt ausgebildet.

In weiterer Ausgestaltung der Erfindung ist eine zweite Stromzuführung durch einen der aktiven Schicht verbundenen elektrischen Kontakt ausgebildet.

Vorteilhaft sind die Stromzuführungen und/oder die Isolierungsschicht für das emittiere Licht reflektierend. Hierdurch ist die Lichtausbeute weiter durch Vermeidung von Verlusten erhöht.

Mit Vorteil ist eine Reflektionseinrichtung für das emittierte Licht auf der der Lichtaustrittsfläche abgewandten Seite der aktiven Schicht in oder auf der Fensterschicht oder der aktiven Schicht ausgebildet. Hierdurch ist wiederum die Lichtausbeute weiter durch Vermeidung von Verlusten erhöht. Dem folgend ist die Reflektionseinrichtung ein Bragg-Gitter.

In weiterer Ausgestaltung der Erfindung ist die Fensterschicht und/oder die optische Einrichtung wenigstens teilweise mit einer für das Emissionslicht durchlässigen Umhüllung versehen. Hierdurch wird das lichtemittierende Halbleiterbauelement vor Umwelteinflüssen geschützt. Eine vielen Anwendungen entsprechende äußere Formgebung ist somit ermöglicht.

Das erfindungsgemäße Verfahren zur Herstellung einer Linsenstruktur auf der Oberfläche eines Leuchtiodenchips sieht vor, dass auf einer für den Lichtaus- bzw. -durchtritt vorgesehen Außenfläche des lichtemittierenden Bauelements die Linsenstruktur vermittels eines Fräswerkzeuges oder eines Ätzverfahrens aus dem lichtemittierenden Bauelement und in die Außenfläche hinein geformt wird.

Ein weiterer bevorzugter Verfahrensschritt sieht vor, dass als Linsenstruktur eine sphärische Linse oder eine Fresnel'sche Linse hergestellt wird.

Ein besonders vorteilhafter Verfahrensschritt sieht vor, vermittels einer geeignet geformten Vorrichtung zur Vereinzelung der noch im Waferverband befindlichen lichtemittierenden Bauelemente bei der Trennung derselben die Linsenstruktur gleichzeitig mit der Vereinzelung herzustellen.

Weitere Vorteile, Besonderheiten und zweckmäßige Weiterbildungen der Erfindung ergeben sich aus den Unteransprüchen.

Nachfolgend wird die Erfindung anhand der Zeichnung weiter erläutert. Im Einzelnen zeigen die schematischen Darstellungen in:

Figur 1  eine schematische Querschnitts-Darstellung eines bevorzugten Ausführungsbeispiels einer erfindungsgemäßen lichtemittierenden Halbleiterdiode mit einem lichtemittierenden Bereich der aktiven Schicht;

Figur 1a  eine schematische Querschnitts-Darstellung des Ausführungsbeispiels aus Figur 1 in Blickrichtung X;

Figur 2  eine schematische Querschnitts-Darstellung eines weiteren bevorzugten Ausführungsbeispiels einer erfindungsgemäßen lichtemittierenden Halbleiterdiode mit einer Fresnel-Linsenstruktur;

Figur 3  eine schematische Querschnitts-Darstellung eines weiteren bevorzugten Ausführungsbeispiels einer erfindungsgemäßen lichtemittierenden Halbleiterdiode mit einer Fresnel-Linsenstruktur;

Figur 4  eine schematische Querschnitts-Darstellung eines weiteren bevorzugten Ausführungsbeispiels einer erfindungsgemäßen lichtemittierenden Halbleiterdiode mit mehreren emittierenden Teilleuchtbereichen und einer Mehrfachlinsenstruktur; und

Figur 5  eine schematische Querschnitts-Darstellung durch einen Wafer mit schon vereinzelten und noch zu vereinzelnden lichtemittierenden Halbleiterbauelementen und ein hierzu verwendetes Sägeblatt.

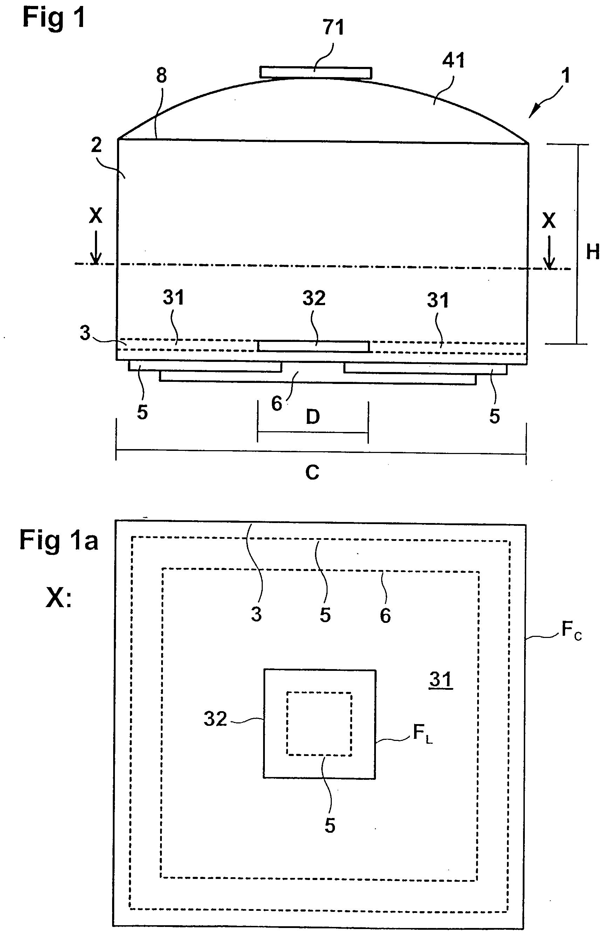

In den folgenden Figuren 1 bis 5 bezeichnen gleiche Bezugsziffern gleiche oder gleich wirkende Elemente.

In Figur 1 ist ein erfindungsgemäßer Leuchtdiodenchip 1 im Querschnitt dargestellt. Das Halbleiterbauelement setzt sich hierbei aus einer für das Emissionslicht strahlungsdurchlässigen Fensterschicht 2, einer das Licht emittierenden aktiven Schicht 3, einer optischen Einrichtung zur Formung des Austrittslichtbündels in Form einer Linse 41, einer Isolierungsschicht 5 als Lichtemissionsbegrenzungseinrichtung und einer ersten Stromzuführung 71 und einer zweiten Stromzuführung 6 zusammen. Die Fensterschicht 2 dient dabei zugleich als Substrat des Leuchtdiodenchips 1.

Der lichtemittierende Bereich 32 der aktiven Schicht 3 ist durch die Maskierung der Isolierungsschicht 5 in seiner Form und Größe beschränkt und bestimmt. Durch die Form der elektrischen Isolierung wird der Kontakt der flächig an der der Lichtaustrittsfläche 8 gegenüberliegenden Unterseite des lichtemittierenden Halbleiterbauelements 1 ausgebildeten Stromzuführung 6 an den Stellen mit dem Chip bzw. mit der aktiven Schicht ermöglicht, oberhalb derer der lichtemittierende Bereich 32 liegt. Im Beispiel kommt als Material der Isolierungsschicht eine Oxidschicht zum Einsatz. Die Stromzuführung 6 kann hierbei durch flächig über der Isolierungsschicht 5 aufgebrachtes Metall ausgebildet sein. Durch die nicht zur Emission vorgesehenen Bereiche 31 der aktiven Schicht 3 fließt somit kein Strom, wodurch keine Lichtemission in diesen Bereichen stattfindet. Die zweite Stromeinspeisung erfolgt durch die auf der elektrisch leitenden Linse 41 in Form eines elektrischen Kontakts ("Pad") ausgebildete erste Stromzuführung 71, auf der ein Bond-Draht in üblicher Weise befestigt werden kann.

Das Emissionslicht aus dem lichtemittierenden Bereich 32 der aktiven Schicht 3, dessen Gesamtfläche $F_L$ die bereits genannte Bedingung

$$ F_L \ \leq \ \left( n_M \middle/ n_S \right)^2 \ \cdot \ F_C $$

erfüllt, durchstrahlt die Fensterschicht 2 mit dem Brechungsindex $n_S$ und der Dicke H, wobei gilt:

$$ H \ = \ \left( C \ - \ D \right) \ \cdot \ \left( 2 \ \cdot \ \left( n_S \middle/ n_M \right) \right)^{-1} $$

Nachfolgend wird das Emissionslicht an der Lichtaustrittsfläche 8 in den Linsenkörper 41 eingekoppelt und das Austrittslichtbündel entsprechend der Linsenformung gestaltet.

Für die Dicke der Fensterschicht ergibt sich beispielsweise für ein Chip mit der Seitenlänge C=300$\mu$m mit $n_S/n_M$=3,5 im Optimalfall D=100$\mu$m und H=30$\mu$m.

Hierbei ist vorteilhafterweise der Brechungsindex der Fensterschicht 2 und des Materials des Linsenkörpers 41 möglichst ähnlich, um die erwähnten Reflektionsverluste zu vermeiden. Am besten wird die optische Einrichtung aus der Fensterschicht 2 selbst hergestellt.

In Figur 1a ist das lichtemittierende Halbleiterbauelement 1 aus Figur 1 in Blickrichtung X dargestellt. Die aktive Schicht 3 nimmt hierbei die gesamte Querschnittsfläche $F_C$ (im Rechenbeispiel von oben 90.000 $\mu$m$^2$) des Halbleiterbauelements ein. Der lichtemittierende Bereich 32 weist die Gesamtfläche $F_L$ (im Rechenbeispiel von oben 10.000 $\mu$m$^2$) auf.

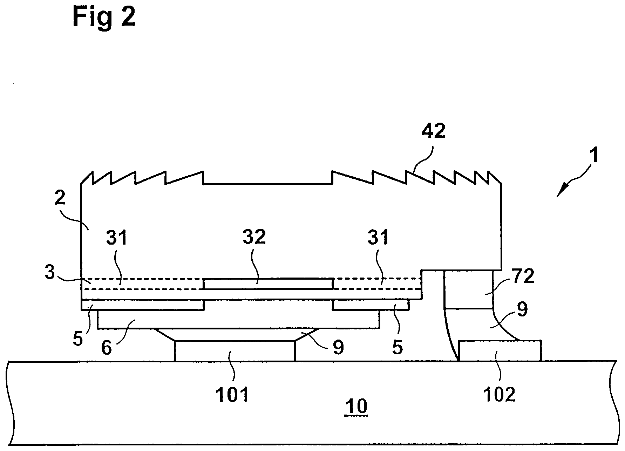

In Figur 2 ist der Querschnitt eines auf einer Platine 10 verlöteten erfindungsgemäßen lichtemittierenden Halbleiterbauelements 1 dargestellt, wobei hier die Stromzuführungen 6 und 72 beide auf der Unterseite des Halbleiterbauelements 1 angebracht sind. Hierdurch ist eine einfachere Verlötung des lichtemittierenden Bauelements 1 mit auf einer Platine 10 ausgebildeten Lötflächen 101 und 102 vermittels eines Lots 9 möglich. Hierdurch sind Lichtquellen in sog. SMD-Bauweise ermöglicht, wobei das lichtemittierende Halbleiterbauelement 1 kaum größer als der Chip selbst ist. Wiederum ist die aktive Schicht 3 flächig ausgebildet und der lichtemittierende Bereich 32 durch eine Isolierungsschicht 5 als Lichtemissionsbegrenzungseinrichtung bestimmt. Anstelle wie in Figur 1 einer Linse 41 findet hier als optische Einrichtung zur Veränderung des Austrittslichtbündels eine sogenannte Fresnel-Linse 42 Anwendung, die vermittels des erfindungsgemäßen Verfahrens durch schnell rotierende Fräswerkzeuge oder geeignete Ätztechniken über dem lichtemittierenden Bereich 32 auf der Lichtaustrittsoberfläche der Fensterschicht 2 ausgebildet wird.

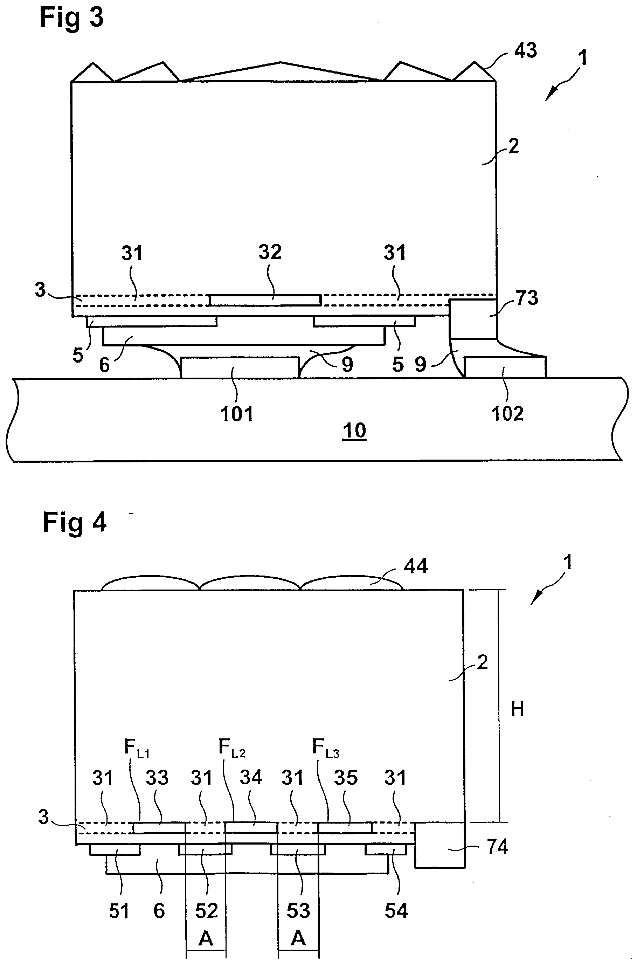

In Figur 3 ist ein weiterer im Querschnitt dargestellter - verlöteter Leuchtdiodenchip 1 dargestellt, wobei vermittels einer Stromzuführung 73 die Stromeinspeisung innerhalb der aktiven Schicht 3 erfolgt. Als optische Einrichtung kommt hier eine nachträglich aufgeprägte Fresnel-Linse 43 zum Einsatz.

Figur 4 zeigt eine weitere Querschnittsdarstellung durch einen Leuchtdiodenchip 1, wobei mehrere lichtemittierende Bereiche 33 bis 35 vorgesehen sind, deren Gesamtfläche der einzelnen Flächen $F_{Li}$ die Gesamtfläche $F_L$ des lichtemittierenden Bereichs darstellten, die wiederum die o.g. Bedingung zum Verhältnis der $F_L$ zur Grundfläche $F_C$ des Chips, und damit der Fläche der Lichtaustrittsfläche, erfüllt.

Die Höhe H der zu durchstrahlenden Fensterschicht 2 ist hierbei als das 0,5- bis 5-fache des Abstandes A der einzelnen Teilleuchtbereiche 33 bis 35 zu wählen. Im dargestellten Beispiel sind als optische Einrichtung zur Veränderung der Lichtbündelcharakteristik mehrere sphärische Linsen 44 vorgesehen, deren Mittelpunkt jeweils über dem Schwerpunkt eines Teilleuchtbereichs 33 bis 35 befindlich ist. Hier sind anstelle der Linsen 44 ebenso mehrere Fresnel'sche Linsen möglich.

Die Fensterschicht 2 kann vorteilhafterweise auch eine gewachsene Epitaxieschicht aus einem für das emittierte Licht durchsichtigem Material sein. Einzelne Epitaxieschichten oder auch das Epitaxie-Ausgangsmaterial, oft auch als das "Substrat" im engeren Sinne der Epitaxie-Verfahrenstechnik bezeichnet, können ganz oder teilweise in bekannten Verfahren entfernt, z.B. abgeätzt werden. Ebenso ist es verfahrenstechnisch möglich verschiedene Materialschichten mechanisch und vor allem optisch "lückenlos" miteinander zu verbinden, beispielsweise durch anodisches Bonden oder durch Aufeinanderpressen sehr ebener Oberflächen.

Die hier vorgestellten Strukturen können also auf sehr verschiedene Weise hergestellt sein.

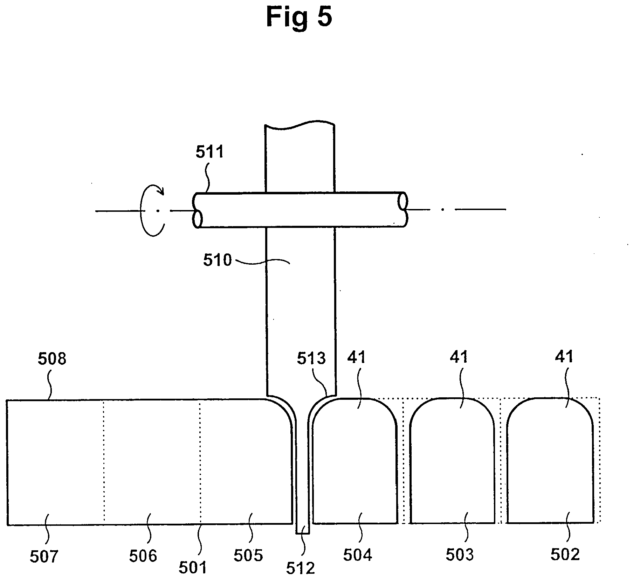

In Figur 5 ist schließlich eine schematische Querschnittsdarstellung durch einen Wafer 501 mit schon vereinzelten 502 bis 504 und noch zu vereinzelnden 505 bis 507 - Leuchtdiodenchips gezeigt. Die optischen Linsen 41 werden durch das entsprechend geformte um die Achse 511 rotierende Sägeblatt 510 gleichzeitig mit der Vereinzelung in die Oberfläche 508 des Wafers 501 hinein hergestellt.

Das Sägeblatt 510 weist in seinem Querschnitt einen dünneren, spitz zulaufenden Teil 512 und einen der herzustellenden Form der Linse (negativ) entsprechenden, sich verbreiternden Teil 513 auf. Das Sägeblatt kann auch so ausgestaltet sein, dass der spitz zulaufende Teil 512 kürzer ist, so dass in die Oberfläche eines Leuchtdiodenchips eine MehrfachlinsenStruktur eingebracht werden kann.

**Patentansprüche**

1. Lumineszenzdiodenchip (1) mit einem Medium, wobei

   - das Medium einem Brechungsindex $n_M$ aufweist, mit einem strahlungsemittierenden aktiven Bereich (32) mit einer lateralen Querschnittsfläche $F_L$ und einer dem strahlungsemittierenden aktiven Bereich (32) in Abstrahlungsrichtung nachgeordneten strahlungsdurchlässigen Fensterschicht (2) mit einem Brechungsindex ns, die zur Lichtauskopplung eine laterale Querschnittsfläche $F_C$ aufweist und die eine Auskoppelfläche besitzt, an die das Medium angrenzt, und
   - die Querschnittsfläche $F_L$ des strahlungsemittierenden aktiven Bereichs (32) kleiner als die Querschnittfläche $F_C$ der Auskoppelfläche ist, wobei gilt: $F_L \leq (n_M/n_S)^2 F_C$,

   **dadurch gekennzeichnet,**
   **dass** $H = (C-D) (2n_S/n_M)^{-1}$,
   wobei H die Dicke der Fensterschicht, C die laterale Querschnittslänge der Fensterschicht (2) und somit der Lichtaustrittsfläche und D die laterale Querschnittslänge des strahlungsemittierenden aktiven Bereiches (32) ist.

2. Lumineszenzdiodenchip nach Anspruch 1,
   **dadurch gekennzeichnet,**
   **dass** der strahlungsemittierdende aktive Bereich (32), mittels Begrenzung des Stromflusses auf die Fläche $F_L$ des strahlungsemittierenden aktiven Bereichs (32) definiert ist.

3. Lumineszenzdiodenchip nach einem der Ansprüche 1 bis 2,
   **dadurch gekennzeichnet,**
   **dass** auf der Fensterschicht (2) eine optische Einrichtung (41, 42, 43, 44) zur Bündelung der elektromagnetischen Strahlung vorgesehen ist.

4. Lumineszenzdiodenchip nach dem vorherigen Anspruch,
   **dadurch gekennzeichnet,**
   **dass** die optische Einrichtung durch eine Linse (41), deren Mittelpunkt über dem Schwerpunkt des strahlungsemittierenden aktiven Bereichs (32) liegt, oder durch mehrere Linsen (44), deren Mittelpunkte über dem Schwerpunkt eines jeweils zugeordneten aktiven Teilleuchtbereichs (33, 34, 35) liegen, ausgebildet ist.

5. Lumineszenzdiodenchip nach dem vorherigen Anspruch,
   **dadurch gekennzeichnet,**
   **dass** die Linsen (41,44) zumindest teilweise als Fresnel'sche Linsen (42, 43) oder als sphärische Linsen ausgebildet sind.

6. Lumineszenzdiodenchip nach einem der Ansprüche 1 bis 5,
   **dadurch gekennzeichnet,**
   **dass** die Fläche $F_L$ bzw. Flächen $F_{Li}$ des strahlungsemittierenden aktiven Bereichs (32, 33, 34, 35) durch Beschränkung der Leuchtfähigkeit einer aktiven Schicht (3) auf die Fläche $F_L$ bzw. Flächen $F_{Li}$ des strahlungsemittierenden aktiven Bereichs (32, 33, 34, 35) definiert ist.

7. Lumineszenzdiodenchip nach einem der Ansprüche 1 bis 6,
   **dadurch gekennzeichnet,**
   **dass** die Fläche $F_L$ bzw. Flächen $F_{Li}$ des strahlungsemittierenden aktiven Bereichs (32, 33, 34, 35) durch eine auf oder an einer aktiven Schicht (3) ausgebildete Isolierungsschicht definiert ist, die aus einem für das Emissionslicht der aktiven Schicht wenigstens teilweise undurchsichtigem und/oder begrenzt durchscheinendem Material gebildet ist.

8. Lumineszenzdiodenchip nach einem der Ansprüche 1 bis 7,
   **dadurch gekennzeichnet,**
   **dass** die Fläche $F_L$ bzw. Flächen $F_{Li}$ des strahlungsemittierenden aktiven Bereichs (32, 33, 34, 35) durch eine auf oder an einer aktiven Schicht (3) und zwischen der aktiven Schicht (3) und einer Stromzuführung (6) ausgebildeten Isolierungsschicht (5) definiert ist, die die Stromzuführung bzw. den Stromfluss zur bzw. durch die aktive Schicht (3) in Bereichen (31) außerhalb des lichtemittierenden Bereichs (32, 33, 34, 35) minimiert.

9. Lumineszenzdiodenchip nach dem vorherigen Anspruch,
   **dadurch gekennzeichnet,**
   **dass** die Isolierungsschicht (5) aus einer nichtleitenden Oxidschicht besteht, die an der der Lichtaustrittsfläche (8) des Chips gegenüberliegen Seite aufgebracht ist.

10. Lumineszenzdiodenchip nach einem der Ansprüche 8 bis 9,
    **dadurch gekennzeichnet,**
    **dass** eine zweite Stromzuführung (71) durch einen auf der Lichtaustrittsfläche (8) oder auf der optischen Einrichtung (41, 42, 43, 44) diese nicht vollständig bedeckenden elektrischen Kontakt ausgebildet ist.

11. Lumineszenzdiodenchip nach einem der Ansprüche 8 bis 9,

**dadurch gekennzeichnet,**
**dass** eine zweite Stromzuführung (72) durch einen mit der Fensterschicht (2) verbundenen und auf der der Lichtaustrittsfläche (8) abgewandten Seite der Fensterschicht (2) angeordneten elektrischen Kontakt ausgebildet ist.

12. Lumineszenzdiodenchip nach einem der Ansprüche 8 bis 9,
**dadurch gekennzeichnet,**
**dass** eine zweite Stromzuführung (73) durch einen der aktiven Schicht verbundenen elektrischen Kontakt ausgebildet ist.

13. Lumineszenzdiodenchip nach einem der Ansprüche 7 bis 12,
**dadurch gekennzeichnet,**
**dass** die Stromzuführungen (6, 71, 72, 73, 74) und/oder die Isolierungsschicht (5) für das emittiere Licht reflektierend sind.

14. Lumineszenzdiodenchip nach einem der vorangehenden Ansprüche,
**dadurch gekennzeichnet,**
**dass** eine Reflektionseinrichtung für das emittierte Licht auf der der Lichtaustrittsfläche (8) abgewandten Seite der aktiven Schicht (3) in oder auf der Fensterschicht (2) oder der aktiven Schicht (3) ausgebildet ist.

15. Lumineszenzdiodenchip nach dem vorherigen Anspruch,
**dadurch gekennzeichnet,**
**dass** die Reflektionseinrichtung ein Bragg-Gitter ist.

16. Lumineszenzdiodenchip nach einem der vorangehenden Ansprüche,
**dadurch gekennzeichnet,**
**dass** die Fensterschicht (2) und/oder die optische Einrichtung (41, 42, 43, 44) wenigstens teilweise mit einer für das Emissionslicht durchlässigen Umhüllung versehen ist.

17. Lumineszenzdiodenchip nach einem der vorangehenden Ansprüche,
**dadurch gekennzeichnet,**
**dass** es eine lichtemittierende Diode ist.

18. Verfahren zur Herstellung eines lichtemittierenden Bauelements nach einem der Ansprüche 4 bis 17,
**dadurch gekennzeichnet,**
**dass** auf einer für den Lichtaus- bzw. -durchtritt vorgesehen Außenfläche (8) des lichtemittierenden Bauelements (1) die Linsenstruktur (41, 42, 43) vermittels eines Fräs- oder Sägewerkzeuges oder eines Ätzverfahrens aus dem lichtemittierenden Bauelement (1) und in die Außenfläche (8) hinein geformt wird.

19. Verfahren nach dem vorherigen Anspruch,
**dadurch gekennzeichnet,**
**dass** als Linsenstruktur eine sphärische Linse (41) oder eine Fresnel'sche Linse (42, 43) hergestellt wird.

20. Verfahren nach Anspruch 18 oder 19,
**dadurch gekennzeichnet,**
**dass** die Linsenstruktur (41, 42, 43) vermittels einem durch ein Säge-(510) oder Fräswerkzeug zur und bei der Vereinzelung der noch im Waferverband befindlichen einzelnen lichtemittierenden Bauelemente hergestellt wird.

21. Verfahren nach dem vorherigen Anspruch,
**dadurch gekennzeichnet,**
**dass** das Säge- (510) oder Fräswerkzeug ein schmales Teil (512) zur Trennung der einzelnen Halbleiterbauelemente (502, 503, 504, 505, 506, 507) vom Waferverband (501) und ein der herzustellenden Form der Linse (41) entsprechend geformtes Teil (513) zur Herstellung der Linse (41) aufweist.

**Claims**

1. Luminescence diode chip (1) with a medium, wherein

    - the medium has a refractive index $n_M$, having a radiation-emitting active region (32) with a lateral cross-sectional area ($F_L$) and a window layer (2) arranged downstream of the radiation emitting active region in radiation direction and having a refractive index ns, the window layer having a cross-sectional area ($F_C$) for light out-coupling, the cross-sectional having an out-coupling area, which adjoins the medium, and

    the lateral cross-sectional area ($F_L$) of the radiation emitting active region is less than the lateral cross-sectional area ($F_C$) of the chip (1), wherein $F_L \leq (n_M/n_S)^2 F_C$,
    **characterized**
    **in that** $H=(C-D) (2n_M/n_S)^{-1}$,
    where H is the thickness of the window layer, C is the lateral cross-sectional length of the window layer (2) and such of the light exit surface and D is the lateral cross-sectional length of the radiation emitting active region (32) .

2. Luminescence diode chip according to claim 1,
**characterized**
**in that** the radiation-emitting active region (32) is defined by means of limiting the current flow to the area ($F_L$) of the radiation-emitting active region (32).

3. Luminescence diode chip according to one of claims 1 to 2,
**characterized**
**in that** an optical device (41, 42, 43, 44) for concentrating the electromagnetic radiation is provided on the window layer (2).

4. Luminescence diode chip according to preceding claim,
**characterized**
**in that** the optical device is formed by one (41) spherical lens, the midpoint of which lies above the centroid of the radiation-emitting active region (32), or in that the optical device is formed by a plurality (44) of spherical lenses, the midpoints of which lie above the centroid of a respectively assigned active partial luminous region (33 to 35).

5. Luminescence diode chip according to the preceding claim,
**characterized**
**in that** the lenses (41, 44) are formed at least partially as Fresnel lenses (42, 43) or spherical lenses.

6. Luminescence diode chip according to one of claims 1 to 5,
**characterized**
**in that** the area $F_L$ or areas $F_{Li}$ of the radiation-emitting active region (32, 33, 34, 35) are defined by restricting the luminous capability of an active layer (3) to the area $F_L$ or areas $F_{Li}$ of the radiation-emitting active region (32, 33, 34, 35).

7. Luminescence diode chip according to one of claims 1 to 6,
**characterized**
**in that** the area $F_L$ or areas $F_{Li}$ of the radiation-emitting active region (32, 33, 34, 35) is or are defined by an insulation layer that is formed on or at an active layer (3) and is formed from a material that is at least partly nontransparent and/or exhibits limited translucency to the emission light of the active layer.

8. Luminescence diode chip according to one of claims 1 to 7,
**characterized**
**in that** the area $F_L$ or areas $F_{Li}$ of the radiation-emitting active region (32, 33, 34, 35) is or are defined by an insulation layer (5) that is formed on or at an active layer (3) and between the active layer (3) and a current feed (6) and minimizes the current feed or the current flow to or through the active layer (3) in regions (31) outside the light-emitting region (32, 33, 34, 35).

9. Luminescence diode chip according to the preceding claim,
**characterized**
**in that** the insulation layer (5) consists of a nonconductive oxide layer applied at the side opposite to the light exit area (8) of the chip.

10. Luminescence diode chip according to one of claims 8 to 9,
**characterized**
**in that** a second current feed (71) is formed by an electrical contact which, on the light exit area (8) or on the optical device (41, 42, 43, 44), does not completely cover the latter.

11. Luminescence diode chip according to one of claims 8 to 9,
**characterized**
**in that** a second current feed (72) is formed by an electrical contact connected to the substrate and arranged on the side of the window layer remote from the light exit area (8).

12. Luminescence diode chip according to one the claims 8 to 9,
**characterized**
**in that** a second current feed (73) is formed by an electrical contact connected to the active layer.

13. Luminescence diode chip according to one of claims 7 to 12,
**characterized**
**in that** the current feeds (6, 71, 72, 73, 74) and/or the insulation layer (5) are reflective to the emitted light.

14. Luminescence diode chip according to one of the preceding claims,
**characterized**
**in that** a reflection device for the emitted light is formed on that side of the active layer (3) which is remote from the light exit area (8) in or on the window layer or the active layer (3).

15. Luminescence diode chip according to the preceding claim,
**characterized**
**in that** the reflection device is a Bragg grating.

16. Luminescence diode chip according to one of the preceding claims,
**characterized**
**in that** the window layer (2) and/or the optical device (41, 42, 43, 44) is at least partly provided with an encapsulation that is transmissive to the emission light.

17. Luminescence diode chip according to one of the preceding claims,
**characterized**
**in that** it is a light-emitting diode.

**18.** Method for producing a light-emitting component according to one of claims 4 to 17, **characterized in that**, on an outer area (8) of the light-emitting component (1) provided for light exit or passage, the lens structure (41, 42, 43) is shaped from the light-emitting component (1) and into the outer area (8) by means of a milling or sawing tool or an etching method.

**19.** Method for producing a lens structure according to the preceding claim, **characterized in that** a spherical lens (41) or a Fresnel lens (42, 43) is produced as the lens structure.

**20.** Method for producing a lens structure according to claim 18 or 19, **characterized in that** the lens structure is produced by means of a sawing (510) or milling tool for and during the singulation of the individual light-emitting components still situated in the wafer assemblage.

**21.** Method for producing a lens structure according to the preceding claim, **characterized in that** the sawing (510) or milling tool has a narrow part (512) for separating the individual semiconductor components (502, 503, 504, 505, 506, 507) from the wafer assemblage (501) and a part (513) for producing the lens (41), said part being shaped in a manner corresponding to the shape of the lens (41) to be produced.

**Revendications**

**1.** Puce de diode électroluminescente (1) avec un milieu,

- le milieu présentant un indice de réfraction $n_M$, avec une zone active d'émission du rayonnement (32), une surface en coupe transversale latérale $F_L$ et une couche-fenêtre (2) transparente au rayonnement agencée en aval de la zone active d'émission du rayonnement (32) dans la direction de la diffusion avec un indice de réfraction $n_s$, qui présente pour le couplage de la lumière une surface en coupe transversale latérale $F_c$ et qui possède une surface de couplage qui jouxte le milieu et
- la surface en coupe transversale latérale $F_L$ de la zone active d'émission du rayonnement (32) étant plus petite que la surface en coupe transversale $F_c$ de la surface de couplage, où prévaut : $F_L \leq (n_M/n_s)\, F_c$, **caractérisée en ce que**

$$H = (C-D)\ (2n_s/n_M)^{-1},$$

H étant l'épaisseur de la couche-fenêtre, C la longueur latérale en coupe transversale de la couche-fenêtre (2) et donc de la surface d'émission de lumière et D la longueur latérale en coupe transversale de la zone active d'émission du rayonnement (32).

**2.** Puce de diode électroluminescente selon la revendication 1, **caractérisée en ce que** la zone active d'émission du rayonnement (32) est définie au moyen du limitation le débit du courant électrique sur la surface $F_L$ de la zone active d'émission du rayonnement (32).

**3.** Puce de diode électroluminescente selon l'une quelconque des revendications 1 à 2, **caractérisée en ce qu'**un dispositif optique (41, 42, 43, 44) est prévu sur la couche-fenêtre (2) pour concentrer le rayonnement électromagnétique.

**4.** Puce de diode électroluminescente selon la revendication précédente, **caractérisée en ce que** le dispositif optique est formé par une lentille (41), dont le point central se trouve au dessus du centre de gravité de la zone active d'émission du rayonnement (32), ou d'une pluralité de lentilles (44), dont les points centraux se trouvent au-dessus du centre de gravité d'une zone partiellement lumineuse active (33, 34, 35) respectivement assignée.

**5.** Puce de diode électroluminescente selon la revendication précédente, **caractérisée en ce que** les lentilles (41, 44) sont au moins partiellement sous forme des lentilles de Fresnel (42, 43) ou des lentilles sphériques.

**6.** Puce de diode électroluminescente selon l'une quelconque des revendications 1 à 5, **caractérisée en ce que** la surface $F_L$ ou des surfaces $F_{Li}$ de la zone active d'émission du rayonnement (32, 33, 34, 35) est/sont définies en limitant la luminosité d'une couche active (3) sur la surface $F_L$ ou les surfaces $F_{Li}$ de la zone active d'émission du rayonnement (32, 33, 34, 35).

**7.** Puce de diode électroluminescente selon l'une quelconque des revendications 1 à 6, **caractérisée en ce que** la surface $F_L$ ou des surfaces $F_{Li}$ de la zone active d'émission du rayonnement (32, 33, 34, 35) est/sont définies par une couche isolante formée sur ou à une couche active (3) qui se compose d'un matériau présentant une translucidité limitée et/ou au moins partiellement opaque pour la lumière d'émission de la couche active.

**8.** Puce de diode électroluminescente selon l'une quelconque des revendications 1 à 7, **caractérisée en ce que** la surface $F_L$ ou des surfaces $F_{Li}$ de la zone active d'émission du rayonnement (32, 33, 34, 35) est/sont définie(s) par une couche isolante (5) formée sur ou à une couche active (3) et entre la couche active (3), et une alimentation électrique (6) qui réduit au minimum l'alimentation en courant ou le débit du courant vers ou à travers la couche active (3) dans des zones (31) en dehors de la zone d'émission de lumière (32, 33, 34, 35).

**9.** Puce de diode électroluminescente selon la revendication précédente, **caractérisée en ce que** la couche isolante (5) consiste en une couche d'oxyde non conductrice qui est appliquée au niveau du côté opposé à la surface de sortie de lumière (8) de la puce.

**10.** Puce de diode électroluminescente selon l'une quelconque des revendications 8 à 9, **caractérisée en ce qu'**une deuxième alimentation en courant (71) est formée par un contact électrique ne recouvrant pas intégralement celle-ci sur la surface d'émission de lumière (8) ou sur le dispositif optique (41, 42, 43, 44).

**11.** Puce de diode électroluminescente selon l'une quelconque des revendications 8 à 9, **caractérisée en ce qu'**une deuxième alimentation en courant (72) est formée par un contact électrique relié à la couche-fenêtre (2) et agencé sur le côté opposée à la surface,d'émission de lumière (8) de la couche-fenêtre (2).

**12.** Puce de diode électroluminescente selon l'une quelconque des revendications de 8 à 9, **caractérisée en ce qu'**une deuxième alimentation en courant (73) est formée par un contact électrique relié à la couche active.

**13.** Puce de diode électroluminescente selon l'une quelconque des revendications 7 à 12, **caractérisée en ce que** les alimentations en courant (6, 71, 72, 73, 74) et/ou la couche isolante (5) sont réfléchissantes pour la lumière émise.

**14.** Puce de diode électroluminescente selon l'une quelconque des revendications précédentes, **caractérisée en ce qu'**un dispositif de réflexion pour la lumière émise est formé sur le côté opposé à la surface d'émission de lumière (8) de la couche active (3) dans ou sur la couche-fenêtre (2) ou la couche active (3).

**15.** Puce de diode électroluminescente selon la revendication précédente, **caractérisée en ce que** le dispositif de réflexion est un réseau de Bragg.

**16.** Puce de diode électroluminescente selon l'une quelconque des revendications précédentes, **caractérisée en ce que** la couche de fenêtre (2) et/ou le dispositif optique (41, 42, 43, 44) est au moins partiellement pourvu d'un revêtement transmissive pour la lumière d'émission.

**17.** Puce de diode électroluminescente selon l'une quelconque des revendications précédentes, **caractérisée en ce qu'**il s'agit d'une diode émettant de la lumière.

**18.** Procédé de fabrication d'un module d'émission de lumière selon l'une quelconque des revendications 4 à 17, **caractérisé en ce que** sur une surface externe (8) du module d'émission de lumière (1) prévu pour l'émission de lumière ou son passage, la structure de lentille (41, 42, 43) est façonnée au moyen d'un outil de fraisage ou de sciage ou d'un procédé de gravure depuis le module d'émission de lumière (1) et dans la surface externe (8).

**19.** Procédé selon la revendication précédente, **caractérisé en ce qu'**on fabrique une lentille sphérique (41) ou une lentille de Fresnel (42, 43) comme structure de lentille.

**20.** Procédé selon la revendication 18 ou 19, **caractérisé en ce que** la structure de lentille (41, 42, 43) est produite au moyen d'un outil de sciage (510) ou de fraisage en vue de la séparation et lors de la séparation d'un seul module d'émission de lumière se trouvant encore dans la tranche composite.

**21.** Procédé selon la revendication précédente, **caractérisé en ce que** l'outil de sciage (510) ou de fraisage présente, pour la fabrication de la lentille (41), une partie étroite (512) destinée à séparer les modules individuels des semiconducteurs (502, 503, 504, 505, 506, 507) dans la tranche composite (501) et une partie formée correspondant à la forme de lentille (41) à fabriquer (513).

**Fig 1**

**Fig 1a**

**X:**

Fig 2

**Fig 3**

**Fig 4**

# Fig 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5233204 A
- WO 9637000 A
- EP 0101368 A
- DE 2633942 A